# FASCICULE DE BREVET EUROPEEN

(11) **EP 1 989 779 B1**
(45) Date de publication et mention de la délivrance du brevet: **31.03.2010**
(21) Numéro de dépôt: 07730916.9
(22) Date de dépôt: 02.02.2007
(51) Int. Cl.: H03K 17/96

(54) **DISPOSITIF DE COMMANDE ELECTRIQUE**
ELEKTRISCHE STEUERVORRICHTUNG
ELECTRICAL CONTROL DEVICE

(30) Priorité: 01.03.2006 FR 0601856
(43) Date de publication de la demande: 12.11.2008
(73) Titulaire: DAV, 94000 Creteil (FR)
(72) Inventeur: LAURENT, Patrice, F-74250 Viuz-en-Sallaz (FR); CHARTRAIN, Cédric, F-74800 La Roche sur Foron (FR)
(74) Mandataire: Benoit, Monique
(86) Numéro de dépôt international: PCT/FR2007/000200
(87) Numéro de publication internationale: WO 2007/099209

(56) Documents cités:
- US-A- 4 314 228
- US-A1- 2002 049 464
- US-A1- 2002 058 104

## Description

La présente invention concerne un dispositif de commande électrique par surface tactile par exemple d'un mécanisme motorisé d'ouverture et / ou de fermeture d'au moins un ouvrant tel qu'une vitre motorisée, un toit ouvrant, un coffre à assistance de fermeture / ouverture motorisé, un hayon motorisé ou encore une porte latérale coulissante motorisée.

On a proposé, plus récemment, d'utiliser pour ces commandes des surfaces tactiles permettant de détecter un appui simple du doigt du conducteur et, en fonction de la position de l'appui détecté et/ou du déplacement ultérieur de cet appui sur la surface, de déclencher un type particulier d'action ou de commande d'organe du véhicule. On pourra se référer par exemple aux documents FR 2 798 329, FR 2 800 885 et US 6 157 372. Ces surfaces tactiles peuvent être de tout type et utiliser différentes technologies.

Ainsi par exemple la technologie utilisant des résistances sensibles à la pression (également connu sous le nom capteur FSR pour « Force Sensing Resistor ») devance de plus en plus d'autres technologies équivalentes, comme par exemple des technologies capacitives ou encore optiques, grâce à sa facilité de mise en oeuvre et à sa robustesse.

De tels capteurs sont par exemple connu sous le nom « tablette digitalisante » (dénomination anglaise "Digitizer pad") et on cite comme art antérieur les documents suivants : US 4,810,992, US 5,008,497, US 2002/0049464, FR 2683649 ou encore EP 0 541 102.

Ces capteurs comprennent des couches semi-conductrices prises en sandwich entre par exemple une couche conductrice et une couche résistive. En exerçant une pression sur la couche FSR, sa résistance ohmique diminue, permettant ainsi, par application d'une tension adaptée, de mesurer la pression appliquée et / ou la localisation de l'endroit où la pression est exercée.

Si l'utilisation de telles surfaces tactiles va indiscutablement dans le sens d'une meilleure convivialité et d'une compacité accrue des dispositifs de commande, elle peut accroître en revanche le risque d'erreur de commande non intentionnelle.

Ainsi, dans le cadre des ouvrants motorisés tels que les vitres, le toit ouvrant ou encore le coffre et / ou le hayon arrière, on connaît des modules de commandes avec plusieurs zones actives adjacentes pour commander des fonctions électriques spécifiques, telles que par exemple l'ouverture, la fermeture, voir le verrouillage d'un ouvrant.

Dans ces modules, le capteur tactile (il peut y avoir une pluralité de capteurs, par exemple un capteur par zone active) est recouvert d'un revêtement, par exemple une peau en silicone, qui présente des nervures en bordure des zones pour délimiter les diverses zones actives.

Les exigences en termes de sûreté de fonctionnement sont sévères et lors de tests effectués, la Demanderesse a constaté que des appuis latéraux sur la nervure d'une zone active peuvent déclencher la commande de la zone adjacente par simple transmission sous forme d'un couple de déformation de la force d'appui.

Quand on sait que ces dispositifs doivent souvent être utilisés en aveugle lors de la conduite du véhicule, on comprend qu'il est nécessaire de pallier à cet inconvénient.

Le but de la présente invention est donc de proposer un dispositif de commande électrique qui diminue le risque des commandes erronées.

A cet effet, l'invention a pour objet un dispositif de commande électrique par surface tactile comprenant au moins deux zones actives adjacentes pour commander dans chaque zone active une fonction électrique spécifique et un revêtement disposé sur la surface tactile et présentant des nervures en surface pour délimiter lesdites zones actives de commande, **caractérisé en ce que** la face inférieure d'une nervure, séparant deux zones actives adjacentes est réalisée à la façon d'une voûte tendue entre deux piliers qui sont uniquement en appui en dehors des zones actives de la surface tactile.

D'autres avantages et caractéristiques apparaîtront à la lecture de la description de l'invention, ainsi que des dessins annexés sur lesquels:
- la figure 1 est une vue en perspective d'un dispositif de commande selon l'invention,
- la figure 2A est une vue en coupe longitudinale d'un détail II du dispositif selon l'invention,
- la figure 2B est une vue par dessus d'un détail II du capteur tactile du dispositif selon l'invention,
- la figure 2C est une vue en coupe transversale d'un détail II du dispositif selon l'invention.

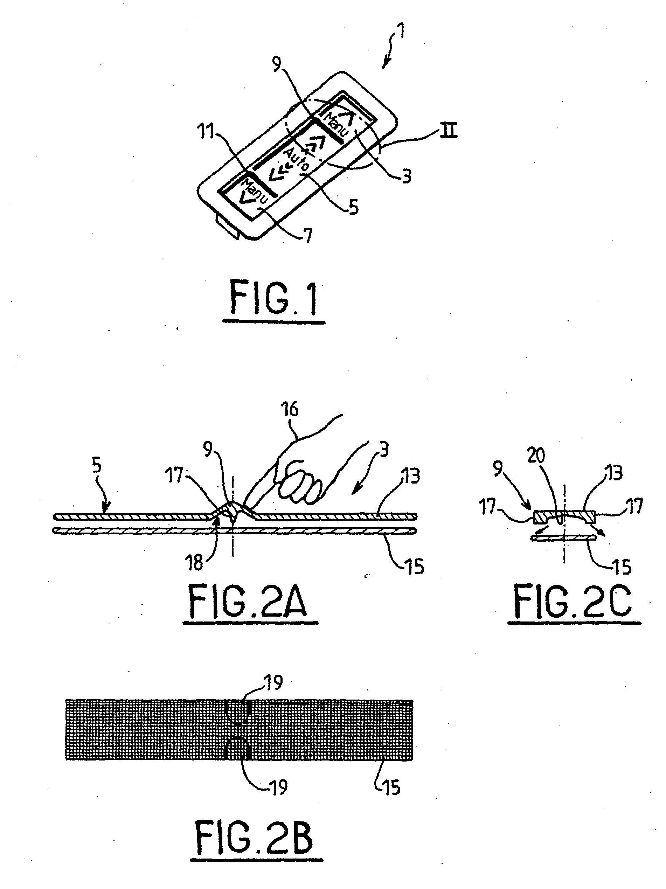

La figure 1 montre une vue en perspective d'un dispositif 1 de commande électrique par surface tactile d'un mécanisme motorisé (non représenté) d'ouverture et/ou de fermeture d'un ouvrant, tel que par exemple une vitre d'un véhicule automobile, un toit ouvrant ou encore le coffre / hayon / porte coulissante motorisé d'un véhicule.

Ce dispositif comprend au moins deux, dans le présent exemple trois zones actives 3, 5 et 7. Le dispositif est configuré de telle manière que chaque zone permette de commander une fonction électrique spécifique.

La zone 3 est par exemple pour une commande de fermeture de l'ouvrant en mode dit « manuel », c'est-à-dire que tant qu'un doigt est en appui sur cette zone, un moteur de déplacement de l'ouvrant est activé et déplace l'ouvrant, au plus jusqu'à venir en butée en position complètement fermée.

De façon analogue, la zone 7 est par exemple pour une commande d'ouverture de l'ouvrant en mode dit « manuel », c'est-à-dire que tant qu'un doigt est en appui sur cette zone, le moteur de déplacement de l'ouvrant est activé et déplace l'ouvrant, au plus jusqu'à venir en butée en position de fermeture complète.

La zone 5 est une zone active dite « glissante », c'est-à-dire que on détecte non seulement l'appui d'un doigt de l'utilisateur, mais aussi son mouvement, en particulier la direction de déplacement d'un doigt de l'utilisateur. En fonction de la direction de mouvement dans cette zone 5, le moteur de déplacement de l'ouvrant ferme (mouvement du doigt en direction de la zone 3) ou ouvre (mouvement du doigt en direction de la zone 7) l'ouvrant.

Les zones actives 3 et 5 ainsi que 5 et 7 sont délimitées entre elles par des nervures en surface 9 et 11. Ces nervures en surface permettent donc d'orienter « haptiquement » l'utilisateur et permettent de réaliser une commande dite « en aveugle ». Optionnellement, sans sortir de la présente invention, on peut envisager que chaque zone est entourée par une telle nervure en surface.

La figure 2A présente en coupe longitudinale un détail II du dispositif de la figure 1.

Sur cette figure, on voit en particulier le revêtement 13 qui est par exemple réalisé en une matière élastique, de préférence en caoutchouc ou silicone, et est disposé sur la surface tactile 15.

La surface tactile 15 est fait partie d'un capteur tactile réalisé selon une technologie connue. Toutefois, de préférence, on utilise un capteur tactile utilisant des résistances sensibles à la pression (également connu sous le nom de capteur FSR pour « Force Sensing Resistor »).

Bien que l'on puisse envisager pour chaque zone active un capteur tactile dédié, on préfère que le dispositif 1 comporte un capteur tactile unique avec une surface tactile pour toutes les zones actives et générant des signaux correspondant aux coordonnées d'appui. Dans ce cas, on exploite les coordonnées délivrées par le capteur pour la réalisation de la commande d'une fonction spécifique électrique associée à la zone touchée par la main d'un utilisateur.

La nervure 9 présente une forme triangulaire en coupe transversale. La face inférieure 18 de la nervure 9, en regard du capteur tactile 15 est réalisée à la façon d'une voûte tendue 20 (voir en particulier la figure 2C) entre par exemple deux piliers 17 (voir la figure 2C présentant une coupe longitudinale du détail II) qui sont uniquement en appui en dehors des zones actives de la surface tactile.

Comme on le voit sur les figures 2A et 2C prises ensemble, les piliers 17 sont disposés aux extrémités de la nervure 9 et forment une jambe centrale d'appui.

Ainsi, un appui latéral contre la nervure 9 (voir par exemple la figure 2A) n'est plus transmis vers une zone active adjacente du dispositif.

De préférence, au niveau de la délimitation de deux zones actives adjacentes 3 et 5 ainsi que 5 et 7, la surface tactile 15 comporte deux régions latérales inactives 19 et les piliers 17 sont en contact avec le capteur 15 dans ces zones 19, également appelées zones mortes.

Une telle disposition est avantageuse, car elle permet de réduire l'encombrement du dispositif selon l'invention.

On comprend donc les avantages de la présente invention, en particulier lorsqu'un doigt glisse par exemple sur la zone active 5 et bute contre une des deux nervures 11 ou 9. Grâce à la configuration spécifique de la face inférieure 18 de la nervure 9, les forces d'appui latéraux sont déviées vers des zones non actives du capteur empêchant ainsi tout risque de dysfonctionnement.

## Revendications

1. Dispositif de commande électrique par surface tactile (15) comprenant au moins deux zones actives adjacentes (3,5,7) pour commander dans chaque zone active (3,5,7) une fonction électrique spécifique et un revêtement (13) disposé sur la surface tactile (15) et présentant des nervures (9) en surface pour délimiter lesdites zones actives de commande (3,5,7), **caractérisé en ce que** la face inférieure (18) d'une nervure (9), séparant deux zones actives adjacentes est réalisée à la façon d'une voûte tendue (20) entre piliers (17) qui sont uniquement en appui en dehors des zones actives de la surface tactile (15).

2. Dispositif selon la revendication 1, **caractérisé en ce que** la nervure (9) présente en coupe transversale une forme générale triangulaire, les piliers (17) étant disposés aux extrémités de la nervure (9) et formant une jambe centrale d'appui.

3. Dispositif selon l'une quelconque des revendications 1 à 2, **caractérisé en ce qu'**au niveau de la délimitation des deux zones actives adjacentes (3,5,7), la surface tactile comporte deux régions latérales inactives (19) et **en ce que** les piliers (17) de la nervure (9) prennent appui sur ces zones inactives (19).

4. Dispositif selon l'une quelconque des revendications précédentes, **caractérisé en ce que** la surface tactile (15) fait partie d'un capteur FSR à résistance variable en fonction de l'appui.

5. Dispositif selon l'une quelconque des revendications précédentes, **caractérisé en ce que** le revêtement (13) est réalisé en une matière élastique, de préférence en caoutchouc ou silicone.

6. Dispositif selon l'une quelconque des revendications précédentes, **caractérisé en ce que** le dispositif comporte une surface tactile (15) unique générant des signaux correspondant aux coordonnées d'appui.

## Claims

1. Tactile surface (15) based electrical control device comprising at least two adjacent active zones (3,5,7) for controlling in each active zone (3,5,7) a specific electrical function and an overlay (13) arranged on the tactile surface (15) and exhibiting surface ribs (9) so as to delimit said active control zones (3,5,7), **characterized in that** the lower face (18) of a rib (9), separating two adjacent active zones, is made in the manner of a tensioned vault (20) between pillars (17) which bear only outside the active zones of the tactile surface (15).

2. Device according to Claim 1, **characterized in that** the rib (9) exhibits a triangular general shape in cross-section, the pillars (17) being arranged at the ends of the rib (9) and forming a central bearing leg.

3. Device according to either of Claims 1 and 2, **characterized in that** at the level of the delimitation of the two adjacent active zones (3,5,7), the tactile surface comprises two inactive lateral regions (19) and **in that** the pillars (17) of the rib (9) bear on these inactive zones (19).

4. Device according to any one of the preceding claims, **characterized in that** the tactile surface (15) forms part of a bearing-dependent variable-resistance FSR sensor.

5. Device according to any one of the preceding claims, **characterized in that** the overlay (13) is made of an elastic material, preferably rubber or silicone.

6. Device according to any one of the preceding claims, **characterized in that** the device comprises a single tactile surface (15) generating signals corresponding to the bearing coordinates.

## Patentansprüche

1. Elektrische Vorrichtung zur Steuerung mittels Berührungsoberfläche (15), die wenigstens zwei benachbarte aktive Zonen (3, 5, 7), um in jeder aktiven Zone (3, 5, 7) eine spezifische elektrische Funktion zu steuern, und eine Beschichtung (13), die auf der Berührungsoberfläche (15) angeordnet ist und Rippen (9) in der Oberfläche aufweist, um die aktiven Steuerzonen (3, 5, 7) zu begrenzen, enthält, **dadurch gekennzeichnet, dass** die untere Fläche (18) einer Rippe (9), die zwei benachbarte aktive Zonen trennt, in der Art einer gespannten Wölbung (20) zwischen Stützen (17), die sich ausschließlich außerhalb der aktiven Zonen der Berührungsoberfläche (15) abstützen, verwirklicht ist.

2. Vorrichtung nach Anspruch 1, **dadurch gekennzeichnet, dass** die Rippe (9) im Querschnitt eine im Allgemeinen dreieckige Form besitzt, wobei die Stützen (17) an den Enden der Rippe (9) angeordnet sind und einen mittigen Abstützfuß bilden.

3. Vorrichtung nach einem der Ansprüche 1 bis 2, **dadurch gekennzeichnet, dass** auf Höhe der Begrenzung von zwei benachbarten aktiven Zonen (3, 5, 7) die Berührungsoberfläche zwei inaktive seitliche Zonen (19) aufweist und dass sich die Stützen (17) der Rippe (9) auf diesen inaktiven Zonen (19) abstützen.

4. Vorrichtung nach einem der vorhergehenden Ansprüche, **dadurch gekennzeichnet, dass** die Berührungsoberfläche (15) einen Teil eines FSR-Sensors mit variablem Widerstand, der von der Aufsetzung abhängt, bildet.

5. Vorrichtung nach einem der vorhergehenden Ansprüche, **dadurch gekennzeichnet, dass** die Beschichtung (13) aus Kunststoff, vorzugsweise aus Gummi oder Silikon, hergestellt ist.

6. Vorrichtung nach einem der vorhergehenden Ansprüche, **dadurch gekennzeichnet, dass** die Vorrichtung eine einzige Berührungsoberfläche (15) aufweist, die Signale erzeugt, die den Aufsetzkoordinaten entsprechen.
